# EUROPEAN PATENT APPLICATION

(11) **EP 4 513 559 A1**
(43) Date of publication of application: **26.02.2025**
(21) Application number: 24194764.7
(22) Date of filing: 15.08.2024
(51) Int. Cl.: H01L 25/075, H10H 20/855, H10H 20/851, H10H 20/856

(54) **DISPLAY DEVICE**

(30) Priority: 21.08.2023 KR 20230108899
(71) Applicant: Samsung Display Co., Ltd., Gyeonggi-do 17113 (KR)
(72) Inventor: MOON, Ji Wook, 17113 Yongin-si (KR); HUH, Jong Moo, 17113 Yongin-si (KR); KIM, Min Woo, 17113 Yongin-si (KR); LEE, Dong Jun, 17113 Yongin-si (KR); LEE, Ju Yon, 17113 Yongin-si (KR)
(74) Representative: Walaski, Jan Filip

(57) **Abstract**

A display device includes a first substrate including emission areas, and a non-emission area between the emission areas, light-emitting elements above the first substrate and respectively in the emission areas, a second substrate above the first substrate, and defining grooves corresponding to the emission areas on a surface facing the first substrate, light conversion layers in the grooves above the light-emitting elements, and reflective layers on sidewalls of the grooves, and surrounding the light conversion layers in plan view.

## Description

### CROSS-REFERENCE TO RELATED APPLICATION

The present application claims priority to Korean Patent Application No. 10-2023-0108899, filed on August 21, 2023, in the Korean Intellectual Property Office.

### BACKGROUND

### 1. Field

The disclosure relates to a display device.

### 2. Description of the Related Art

The importance of display devices has steadily increased with the development of multimedia technology. Accordingly, various types of display devices, such as a liquid crystal display device, a light-emitting display device, and the like have been developed.

### SUMMARY

Aspects of the present disclosure provide a display device capable of reducing or preventing crosstalk caused by light interference between pixels.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an aspect of the present disclosure, there is provided a display device including a first substrate including emission areas, and a non-emission area between the emission areas, light-emitting elements above the first substrate and respectively in the emission areas, a second substrate above the first substrate, and defining grooves corresponding to the emission areas on a surface facing the first substrate, light conversion layers in the grooves above the light-emitting elements, and reflective layers on sidewalls of the grooves, and surrounding the light conversion layers in plan view.

The emission areas may include a first emission area for emitting light of a first color, a second emission area for emitting light of a second color, and a third emission area for emitting light of a third color, wherein the grooves include a first groove corresponding to the first emission area, a second groove corresponding to the second emission area, and a third groove corresponding to the third emission area.

The display device may further include a first color filter in the first groove, above a first light conversion layer in the first groove, and for transmitting light of the first color, a second color filter in the second groove, above a second light conversion layer in the second groove, and for transmitting light of the second color, and a third color filter in the third groove, above a third light conversion layer in the third groove, and for transmitting light of the third color.

The light-emitting elements may include a first light-emitting element in the first emission area, a second light-emitting element in the second emission area, and a third light-emitting element in the third emission area, the first light-emitting element, the second light-emitting element, and the third light-emitting element including first color light-emitting elements for emitting light of the first color.

The light conversion layers may include a first light conversion layer in the first groove, and containing a light-scattering material, a second light conversion layer in the second groove, and including first wavelength conversion particles for converting the light of the first color into the light of the second color, and a third light conversion layer in the third groove, and including second wavelength conversion particles for converting the light of the first color into the light of the third color.

The light conversion layers may include a first light conversion layer in the first groove, and containing a light-scattering material, a second light conversion layer in the second groove, and including phosphors for converting the light of the first color into light of a fourth color, and a third light conversion layer in the third groove, and including phosphors for converting the light of the first color into the light of the fourth color.

The first light-emitting element, the second light-emitting element, and the third light-emitting element may include blue light-emitting elements for emitting blue light.

The light-emitting elements may be partially inserted into the grooves.

The first substrate and the second substrate may include a display area including the emission areas and the non-emission area, and a non-display area surrounding the display area in plan view, wherein the display device further includes a sealing member between the first substrate and the second substrate in the non-display area.

The sealing member may include a melted glass frit.

The first substrate and the second substrate may include glass.

The first substrate may define a first outer groove in the non-display area on a surface facing the second substrate, wherein the second substrate further defines a second outer groove in the non-display area on the surface facing the first substrate.

A portion of the sealing member may be in the first outer groove, wherein another portion of the sealing member is in the second outer groove.

The display device may further include at least one of a first light-blocking pattern on the surface of the second substrate, and in the non-emission area, or a second light-blocking pattern on a surface of the first substrate, and in the non-emission area.

The first light-blocking pattern and the second light-blocking pattern may include a black matrix material, a metal, or color filter materials of at least two colors.

The reflective layers may include at least one metal layer.

The display device may further include pixels in a display area including the emission areas and the non-emission area, and including respective light-emitting elements, respective light conversion layers, and respective reflective layers in the emission areas.

According to an aspect of the present disclosure, there is provided a display device including a first substrate including a first emission area and a second emission area, a first light-emitting element and a second light-emitting element above the first substrate, and respectively in the first emission area and the second emission area, a second substrate above a surface of the first substrate, and defining a first groove and a second groove respectively corresponding to the first emission area and the second emission area on a surface facing the first substrate, a first light conversion layer and a second light conversion layer respectively in the first groove and the second groove, and respectively including first light conversion particles and second light conversion particles, a first color filter and a second color filter respectively in the first groove and the second groove, and respectively above the first light conversion layer and the second light conversion layer, and a first reflective layer and a second reflective layer respectively on sidewalls of the first groove and the second groove, and respectively surrounding the first emission area and the second emission area.

The first light-emitting element and the second light-emitting element may include first color light-emitting elements for emitting light of a first color, wherein the first light conversion particles include a light-scattering material, and wherein the second light conversion particles include wavelength conversion particles or phosphors for converting the light of the first color into light of a second color.

The first color filter may include a color filter of the first color for transmitting the light of the first color, wherein the second color filter includes a color filter of the second color for transmitting the light of the second color.

A display device according to embodiments may include a first substrate, light-emitting elements located in an emission area on the first substrate, a second substrate including or defining grooves corresponding to the emission areas on one surface facing the first substrate, light conversion layers and reflective layers provided in the grooves. In some embodiments, the display device may further include color filters provided in the grooves to be located on top of the light conversion layers. According to embodiments, the crosstalk due to light interference between the pixels may be reduced or prevented, and image quality of the display device may be improved.

However, aspects according to the embodiments of the present disclosure are not limited to those exemplified above and various other effects are incorporated herein.

### BRIEF DESCRIPTION OF THE DRAWINGS

The above and other aspects of the present disclosure will become more apparent by describing in detail embodiments thereof with reference to the attached drawings, in which:
FIG. 1 is a plan view illustrating a display device;
FIG. 2 is a plan view schematically showing a pixel group;
FIG. 3 is a circuit diagram schematically illustrating a pixel;
FIG. 4 is a cross-sectional view illustrating a light-emitting element;
FIG. 5 is a cross-sectional view illustrating the light-emitting element;
FIG. 6 is a cross-sectional view illustrating the display device;
FIG. 7 is a cross-sectional view illustrating the display device;
FIG. 8 is a cross-sectional view illustrating the display device;
FIG. 9 is a cross-sectional view illustrating the display device;
FIG. 10 is a cross-sectional view illustrating the display device;
FIG. 11 is a cross-sectional view illustrating the display device;
FIG. 12 is a cross-sectional view illustrating the display device;
FIG. 13 is a diagram illustrating a smart device including a display device;
FIG. 14 is a diagram illustrating a virtual reality device including a display device;
FIG. 15 is a diagram illustrating an automobile dashboard and center fascia including display devices; and
FIG. 16 is a diagram illustrating a transparent display device including a display device.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the spirit and scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

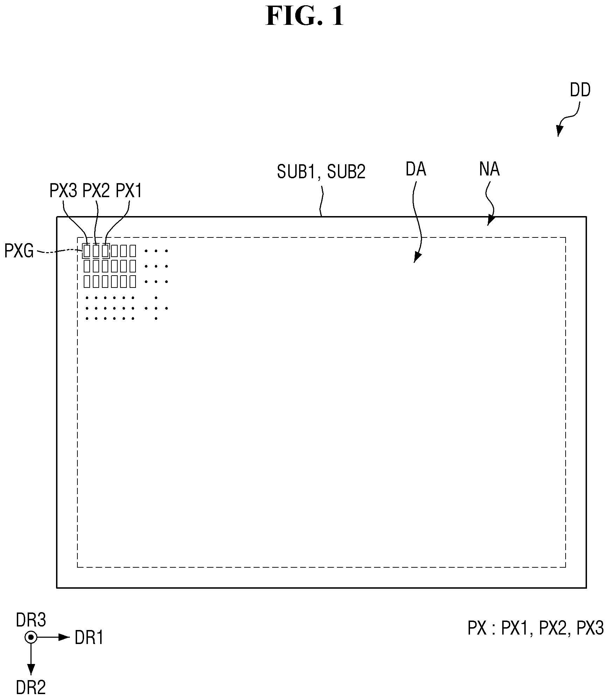

FIG. 1 is a plan view illustrating a display device DD.

In FIG. 1, the structure of the display device DD is briefly illustrated centering on a display panel including a display area DA. The display device DD may further include a driving circuit (e.g., a scan driver, a data driver, and a timing controller) to drive the pixels PX. At least a part of a driving circuit may be formed and/or located in a display panel. The driving circuit may be provided outside the display panel, and may be electrically connected to the display panel.

Referring to FIG. 1, the display device DD may be provided in the form of a panel having a corresponding shape on a plane defined by a first direction DR1 and a second direction DR2 that intersect each other. For example, the display device DD may be provided in the form of a panel having a quadrilateral shape on a plane defined by the first direction DR1 and the second direction DR2. In FIG. 1, the display device DD is illustrated as including an angular corner, but the display device DD may include a rounded corner. In addition, the display device DD may have various shapes. For example, the display device DD may have a non-rectangular polygonal shape, a circular shape, an elliptical shape, or another shape.

The display device DD may be provided as a substantially flat panel having a uniform thickness in a third direction DR3 that intersects (e.g., is perpendicular to) the first direction DR1 and the second direction DR2. In other implementations, the display device DD may be provided as a three-dimensional shaped panel having a curved surface or the like at least in one portion. The display device DD may be a rigid display device that is not substantially transformed, or may be a flexible display device that may be transformed in at least a part thereof, such as being folded, bent, or rolled.

In FIG. 1, the display device DD is illustrated as having a rectangular shape and being substantially flat on a plane defined by the first direction DR1 and the second direction DR2. In addition, in FIG. 1, the horizontal direction (e.g., a row direction or X direction) of the display device DD is referred to as the first direction DR1, the vertical direction (e.g., a column direction or Y direction) of the display device DD is referred to as the second direction DR2, and the thickness direction (e.g., a height direction or Z direction) of the display device DD is referred to as the third direction DR3.

The display device DD may include a first substrate SUB1 and a second substrate SUB2 that overlap each other, and the pixels PX located on the first substrate SUB1 (as used herein, "located on" may mean "located above"). The pixels PX may be located between the first substrate SUB1 and the second substrate SUB2, and may be arranged in the display area DA. In FIG. 1, the first substrate SUB1 and the second substrate SUB2 are illustrated to have substantially the same size and completely overlap each other, but the arrangement is not limited thereto. For example, the second substrate SUB2 may be located on a portion of the first substrate SUB1, and may expose another portion of the first substrate SUB1.

The first substrate SUB1 may be a base member for forming or arranging the pixels PX. For example, at least a part of the pixels PX may be located and/or formed on the first substrate SUB1.

The second substrate SUB2 may be coupled and/or bonded to the first substrate SUB1 on the first substrate SUB1. The second substrate SUB2 may seal the display area DA including the pixels PX. The second substrate SUB2 may include grooves corresponding to the emission areas EA of the pixels PX, and light conversion layers for converting light generated by the pixels PX may be provided in the grooves, respectively. A detailed description in this regard will be given later.

The first substrate SUB1 and the second substrate SUB2 may include the display area DA and a non-display area NA (also referred to as a "bezel area") located around the display area DA. The display area DA is an area in which an image is displayed, and may include emission areas of the pixels PX. The display area DA may be located between the emission areas of the pixels PX, and may further include a non-emission area surrounding the emission areas.

The display area DA may have various shapes. For example, the display area DA may have various shapes, including a quadrilateral shape, a non-quadrilateral polygonal shape, a circular shape, or an elliptical shape.

The pixels PX may be arranged in the display area DA. For example, the display area DA may include pixel areas in which the respective pixels PX are provided and/or located, and the pixels PX may be located in pixel areas on the first substrate SUB1, respectively. Each pixel area may include an emission area that emits light from each of the pixels PX. At least one light-emitting element may be located or provided in each emission area. Each pixel area may further include a pixel circuit area in which circuit elements (e.g., transistors and at least one capacitor constituting each pixel circuit) provided to each of the pixels PX are located or provided. The pixel circuit area of each of the pixels PX may overlap or may not overlap the emission area of the corresponding pixel PX.

The display device DD may include the pixels PX for emitting light of different colors. For example, the display device DD may include first pixels PX1 (or first color sub-pixels) for emitting light of a first color (e.g., blue light), second pixels PX2 (or second color sub-pixels) for emitting light of a second color (e.g., green light), and third pixels PX3 (or third color sub-pixels) for emitting light of a third color (e.g., red light). A primary color of light emitted from each of the pixels PX may vary according to implementation.

At least one first pixel PX1, at least one second pixel PX2, and at least one third pixel PX3 located adjacent to each other may constitute one pixel group PXG (or unit pixel). As an example, each of the pixel groups PXG may include one first pixel PX1, one second pixel PX2, and one third pixel PX3, or may further include additional one of the first pixel PX1, the second pixel PX2, and/or the third pixel PX3 besides one first pixel PX1, one second pixel PX2, and one third pixel PX3. Each of the pixel groups PXG may further include a fourth pixel that emits light of a fourth color (e.g., white light) along with at least one each from the first pixel PX1, the second pixel PX2, and the third pixel PX3. In addition, the type, number, and/or ratio of the pixels PX constituting each of the pixel groups PXG may be variously changed.

Each of the pixels PX may include at least one light-emitting element driven by a driving signal (e.g., at least one scan signal and a data signal) and/or a power voltage (e.g., a first power voltage and a second power voltage). The pixels PX may have a structure to be described below. For example, the pixels PX may have a structure to which any one of the implementations to be described below is applied, or may have a structure to which at least two implementations are applied in combination.

The pixels PX may have various shapes. For example, based on each emission area, each of the pixels PX may have a quadrilateral shape, a non-quadrilateral polygonal shape (e.g., a hexagonal shape, an octagonal shape, or the like), a circular shape, an elliptical shape, or other shapes.

The pixels PX may be arranged in the display area DA according to various arrangement structures. For example, the pixels PX may be arranged in the display area DA in a stripe structure, a delta structure, a PENTILE^{™} structure (PENTILE^{™} being a registered trademark of Samsung Display Co., Ltd., Republic of Korea), or other arrangement structures.

The non-display area NA may be the remaining area excluding the display area DA. Wires connected to the pixels PX, pads, and/or an embedded circuit unit (e.g., a scan driver formed on the display panel together with the pixels PX) may be located in the non-display area NA. The wires, the pads, and/or the embedded circuit unit may be located and/or formed on the first substrate SUB1.

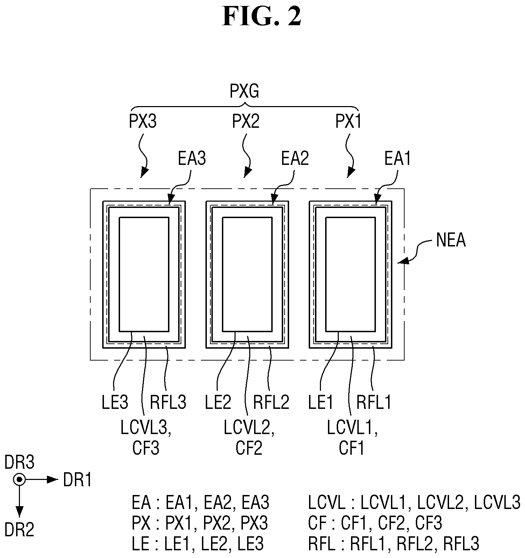

FIG. 2 is a plan view schematically showing the pixel group PXG.

Referring to FIG. 2 in addition to FIG. 1, each of the pixels PX may include each of the emission areas EA located in the display area DA. For example, the first pixel PX1, the second pixel PX2, and the third pixel PX3 may include a first emission area EA1, a second emission area EA2, and a third emission area EA3, respectively.

The emission areas EA of the pixels PX may be spaced apart from each other. For example, the first emission area EA1, the second emission area EA2, and the third emission area EA3 may be spaced apart from each other with a non-emission area NEA therebetween.

Each of the pixels PX may include at least one light-emitting element LE located in each of the emission areas EA. For example, the first pixel PX1 may include a first light-emitting element LE1 located in the first emission area EA1. The second pixel PX2 may include a second light-emitting element LE2 located in the second emission area EA2. The third pixel PX3 may include a third light-emitting element LE3 located in the third emission area EA3.

The light-emitting elements LE of the pixels PX may be located on the first substrate SUB1. For example, the first light-emitting element LE1, the second light-emitting element LE2, and the third light-emitting element LE3 may be provided and/or formed in the first emission area EA1, the second emission area EA2, and the third emission area EA3, respectively, on the first substrate SUB1.

The pixels PX may further include light conversion layers LCVL respectively located in the emission areas EA. For example, the first pixel PX1 may include a first light conversion layer LCVL1 located in the first emission area EA1 and located on the first light-emitting element LE1. The second pixel PX2 may include a second light conversion layer LCVL2 located in the second emission area EA2 and located on the second light-emitting element LE2. The third pixel PX3 may include a third light conversion layer LCVL3 located in the third emission area EA3 and located on the third light-emitting element LE3.

The light conversion layers LCVL of the pixels PX may be located on one surface of the second substrate SUB2. For example, the first light conversion layer LCVL1, the second light conversion layer LCVL2, and the third light conversion layer LCVL3 may be respectively provided and/or formed in the first emission area EA1, the second emission area EA2, and the third emission area EA3 on one surface of the second substrate SUB2 facing the first substrate SUB1. The light conversion layers LCVL of the pixels PX may be provided and/or formed in the grooves formed on (e.g., defined by) one surface of the second substrate SUB2 facing the first substrate SUB1.

Each of the pixels PX may further include color filters CF respectively located in the emission areas EA. For example, the first pixel PX1 may include a first color filter CF1 located in the first emission area EA1 and located on the first light conversion layer LCVL1. The second pixel PX2 may include a second color filter CF2 located in the second emission area EA2 and located on the second light conversion layer LCVL2. The third pixel PX3 may include a third color filter CF3 located in the third emission area EA3 and located on the third light conversion layer LCVL3.

The color filters CF of the pixels PX may be located on one side of the second substrate SUB2. For example, the first color filter CF1, the second color filter CF2, and the third color filter CF3 may be respectively provided and/or formed in the first emission area EA1, the second emission area EA2, and the third emission area EA3, on one surface of the second substrate SUB2 facing the first substrate SUB1. The color filters CF of the pixels PX may be provided and/or formed in the grooves formed on one surface of the second substrate SUB2 along with each of the light conversion layers LCVL.

Each of the pixels PX may further include a reflective layer RFL surrounding each of the emission areas EA and located at the non-emission area NEA (or an edge of each of the emission areas EA). For example, the first pixel PX1 may include a first reflective layer RFL1 located outside the first emission area EA1 to surround the first light conversion layer LCVL1 and the first color filter CF1 that are provided in the first emission area EA1. The second pixel PX2 may include a second reflective layer RFL2 located outside the second emission area EA2 to surround the second light conversion layer LCVL2 and the second color filter CF2 that are provided in the second emission area EA2. The third pixel PX3 may include a third reflective layer RFL3 located outside the third emission area EA3 to surround the third light conversion layer LCVL3 and the third color filter CF3 that are provided in the third emission area EA3.

The reflective layers RFL of the pixels PX may be located on the second substrate SUB2. For example, the first reflective layer RFL1, the second reflective layer RFL2, and the third reflective layer RFL3 may be provided and/or formed in the non-emission area NEA to respectively surround the first emission area EA1, the second emission area EA2, and the third emission area EA3 on one surface of the second substrate SUB2 facing the first substrate SUB1.

The non-emission area NEA may surround the emission areas EA. A part of the non-emission area NEA may be located between the adjacent emission areas EA.

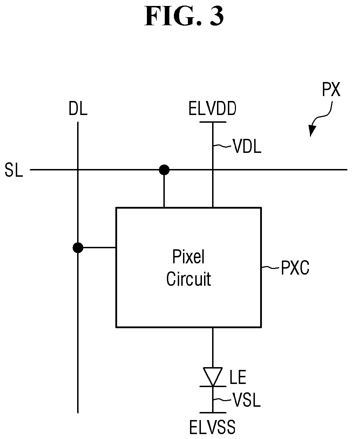

FIG. 3 is a circuit diagram schematically illustrating the pixel PX.

Referring to FIG. 3 in addition to FIGS. 1 and 2, each of the pixels PX may include the light-emitting element LE (or light-emitting unit) connected to a first power line VDL to which a first power voltage ELVDD is applied, and a second power line VSL to which a second power voltage ELVSS is applied. Each of the pixels PX may further include a pixel circuit PXC (or a pixel driver) connected to the light-emitting element LE for controlling the driving current supplied to the light-emitting element LE.

The pixel circuit PXC may be connected between the first power line VDL and the light-emitting element LE. Depending on the structure and/or type of the pixel circuit PXC, the pixel circuit PXC may be connected between the light-emitting element LE and the second power line VSL.

The pixel circuit PXC may be further connected to at least one scan line SL to which at least one scan signal is applied, and a data line DL to which a data signal is applied. Depending on the structure, type, and/or driving method of the pixel circuit PXC, the pixel circuit PXC may be further connected to at least one other power line supplied with an initialization power voltage and/or a bias voltage or the like, and/or an emission control line or the like supplied with an emission control signal.

The pixel circuit PXC may control the driving current supplied to the light-emitting element LE to correspond to the driving signals supplied to the pixel PX. For example, the pixel circuit PXC may control the size and/or the supply timing of the driving current supplied to the light-emitting element LE to correspond to driving signals including scan signals, data signals, or the like.

The pixel circuit PXC may include circuit elements for controlling the driving current flowing through the pixel PX to correspond to driving signals. For example, the pixel circuit PXC may include a switching transistor for transmitting the data signal supplied to the data line DL, to the interior of the pixel during the period when the scan signal of a gate-on voltage is supplied to the scan line SL, a capacitor for storing the data signal, and circuit elements including a driving transistor for generating a driving current corresponding the data signal. The pixel circuit PXC may further include at least one other transistor for compensating for luminance deviation or the like of the pixels PX.

The light-emitting element LE may be connected between the pixel circuit PXC and the second power line VSL. The light-emitting element LE may emit light to correspond to the driving current supplied from the pixel circuit PXC. For example, during the period when a driving current is supplied from the pixel circuit PXC, the light-emitting element LE may emit light with a luminance corresponding to the magnitude of the driving current.

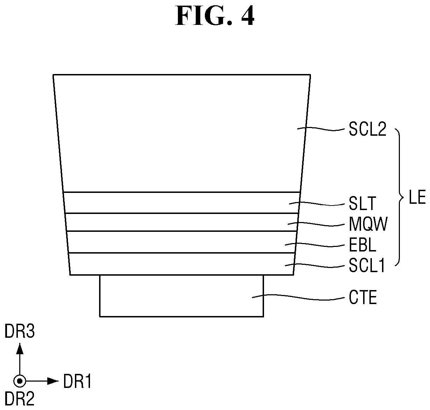

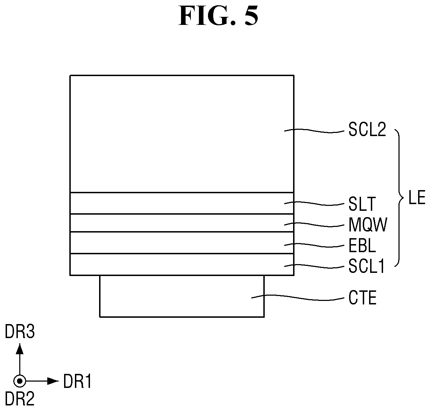

FIG. 4 is a cross-sectional view illustrating the light-emitting element LE. FIG. 5 is a cross-sectional view illustrating the light-emitting element LE. For example, FIGS. 4 and 5 illustrate different implementations with respect to the shape of the light-emitting element LE.

Referring to FIGS. 4 and 5 in addition to FIGS. 1 to 3, the light-emitting element LE may include a first semiconductor layer SCL1, an active layer MQW, and a second semiconductor layer SCL2. The light-emitting element LE may further include an electron-blocking layer EBL and a superlattice layer SLT.

The light-emitting element LE may further include a contact electrode CTE provided at one end. In FIGS. 4 and 5, the contact electrode CTE is illustrated as an element included in the light-emitting element LE, but is not limited thereto. For example, the contact electrode CTE may be formed separately from the light-emitting element LE, and may be provided or located on one end of the light-emitting element LE.

The light-emitting element LE may be an inorganic light-emitting element made of an inorganic material. For example, the light-emitting element LE may be made of a nitride-based semiconductor material, such as GaN, AlGaN, InGaN, AlInGaN, AIN, or InN, such as a phosphide-based semiconductor material, such as GaP, GaInP, AlGaP, AlGaInP, AlP, or InP, or such as other inorganic materials.

The contact electrode CTE may be provided and/or formed at one end of the light-emitting element LE in which the first semiconductor layer SCL1 is located. For example, the contact electrode CTE may be provided and/or formed on one surface of the first semiconductor layer SCL1. The contact electrode CTE may protect the first semiconductor layer SCL1, and may be an electrode for smoothly connecting the first semiconductor layer SCL1 to at least one circuit element, electrode, and/or wire or the like. The contact electrode CTE may include metal, metal oxide, or other conductive materials.

The first semiconductor layer SCL1 may be located on the contact electrode CTE. The first semiconductor layer SCL1 may include a nitride-based semiconductor material, or a phosphide-based semiconductor material. For example, the first semiconductor layer SCL1 may include a nitride-based semiconductor material including at least one material of GaN, AlGaN, InGaN, AlInGaN, AIN, or InN, or a phosphide-based semiconductor material including at least one material of GaP, GaInP, AlGaP, AlGaInP, AlP, or InP. The first semiconductor layer SCL1 may include other materials.

The first semiconductor layer SCL1 may include a semiconductor material doped with a first conductivity type dopant. The first semiconductor layer SCL1 may be made of GaN (e.g., p-GaN) doped with a first conductivity type dopant (e.g., p-type dopant), such as Mg, Zn, Ca, Se, and Ba.

The electron-blocking layer EBL may be located on the first semiconductor layer SCL1. The electron-blocking layer EBL may be a layer for suppressing, reducing, or preventing too many electrons from flowing into the active layer MQW. The electron-blocking layer EBL may be AlGaN or p-AlGaN doped with p-type Mg. The electron-blocking layer EBL may be omitted.

The active layer MQW may be located on the electron-blocking layer EBL (or the first semiconductor layer SCL1). The active layer MQW may emit light by coupling of electron-hole pairs according to an electrical signal applied through the first semiconductor layer SCL1 and the second semiconductor layer SCL2. For example, the active layer MQW may be a light-emitting layer of the light-emitting element LE.

The active layer MQW may include a material having a single or multiple quantum well structure. When the active layer MQW contains a material having a multiple quantum well structure, the active layer MQW may have a structure in which a plurality of well layers and barrier layers are alternately stacked. Alternatively, the active layer MQW may have a structure in which semiconductor materials having large band gap energy, and semiconductor materials having small band gap energy, are alternately stacked. The active layer MQW may include different group III to group V semiconductor materials depending on the wavelength band of the emitted light.

The active layer MQW may include a nitride-based semiconductor material or a phosphide-based semiconductor material. For example, the active layer MQW may include a nitride-based semiconductor material including at least one material of GaN, AlGaN, InGaN, InGaAlN, AIN, InN, or AlInN, or a phosphide-based semiconductor material including at least one material of GaP, GaInP, AlGaP, AlGaInP, AlP, or InP. The well layer may be formed of InGaN, and the barrier layer may be formed of GaN or AlGaN, but are not limited thereto. The active layer MQW may include other materials.

In case that the active layer MQW includes InGaN, the color of emitted light may vary depending on the content of indium (In). For example, as the content of indium (In) increases, the wavelength band of the light emitted by the active layer may shift to the red wavelength band, and as the content of indium (In) decreases, the wavelength band of the light emitted by the active layer may shift to the blue wavelength band. For example, the active layer MQW of the light-emitting element LE that emits light in the blue wavelength band may contain about 10 wt% to 20 wt% of indium.

The superlattice layer SLT may be located on the active layer MQW. The superlattice layer SLT may be a layer for relieving stress between the second semiconductor layer SCL2 and the active layer MQW. The superlattice layer SLT may be formed of InGaN or GaN. The superlattice layer SLT may be omitted.

The second semiconductor layer SCL2 may be located on the superlattice layer SLT (or the active layer MQW). The second semiconductor layer SCL2 may include a nitride-based semiconductor material or a phosphide-based semiconductor material. For example, the second semiconductor layer SCL2 may include a nitride-based semiconductor material including at least one material of GaN, AlGaN, InGaN, AlInGaN, AIN, or InN, or a phosphide-based semiconductor material including at least one material of GaP, GaInP, AlGaP, AlGaInP, AlP, or InP. The second semiconductor layer SCL2 may include other materials.

The second semiconductor layer SCL2 may include a semiconductor material doped with a second conductivity type dopant. The second semiconductor layer SCL2 may be made of GaN (e.g., n-GaN) doped with a second conductivity type dopant (e.g., n-type dopant), such as Si, Ge, and Sn. The first semiconductor layer SCL1 and the second semiconductor layer SCL2 may include the same semiconductor material (e.g., the same nitride-based semiconductor material), but may include dopants of different conductivity types.

The first semiconductor layer SCL1 and the second semiconductor layer SCL2 may have different thicknesses in the thickness direction of the light-emitting element LD (e.g., the third direction DR3). For example, the second semiconductor layer SCL2 may have a greater thickness than the first semiconductor layer SCL1 in the thickness direction of the light-emitting element LD. Accordingly, the active layer MQW may be located closer to the first end (e.g., the p-type end) of the light-emitting element LE provided with the first semiconductor layer SCL1 or the like than to the second end (e.g., the n-type end) of the light-emitting element LE provided with the second semiconductor layer SCL2.

The light-emitting element LE may be a vertical micro LED extending in the third direction DR3. For example, the light-emitting element LE may be the micro LED having a length of several to several hundreds of micrometers (µm) in the first direction DR1, the second direction DR2, and the third direction DR3. Each of the length of the light-emitting element LE in the first direction DR1, the length in the second direction DR2, and the length in the third direction DR3 may be about 100 µm or less.

The light-emitting element LE may have a reverse tapered cross-sectional shape as illustrated in FIG. 4. For example, the light-emitting element LE may have an inverted trapezoidal cross-sectional shape in which the width of the top surface is wider than the width of the bottom surface.

The shape of the light-emitting element LE may be variously changed. For example, the light-emitting element LE may have a trapezoidal cross-sectional shape in which the width of the bottom surface is wider than the width of the top surface.

The light-emitting element LE may include a substantially vertical side surface as illustrated in FIG. 5. For example, the light-emitting element LE may have a rectangular or square cross-sectional shape in which the width of the top surface and the width of the bottom surface are substantially equal.

The material, type, size, and/or shape or the like of the light-emitting element LE are not limited to those described above. For example, the material, type, size, and/or shape of the light-emitting element LE may be variously changed.

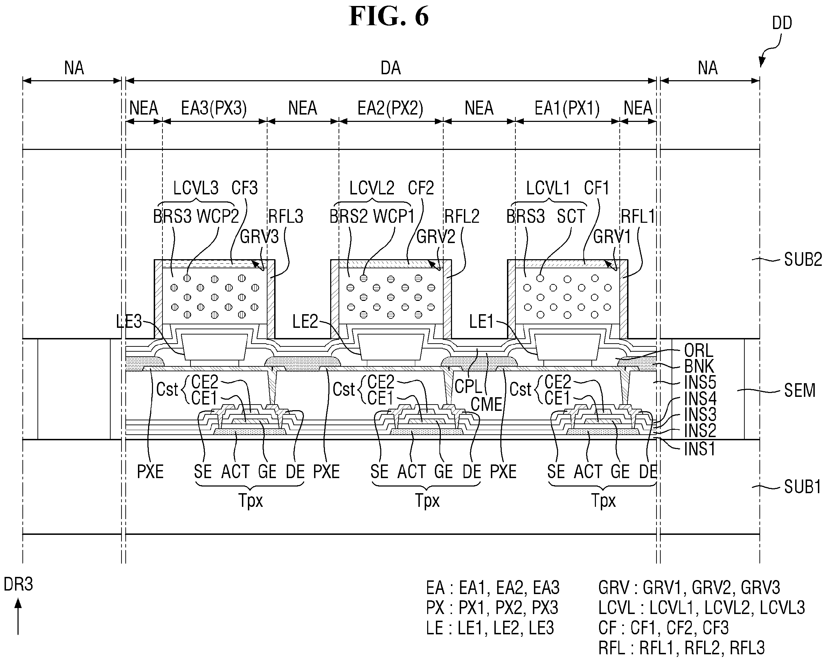

FIG. 6 is a cross-sectional view illustrating the display device DD. For example, FIG. 6 schematically illustrates a cross section of the display device DD for a portion of the display area DA provided with the first pixel PX1, the second pixel PX2, and the third pixel PX3, and for a portion of the non-display area NA provided with a sealing member SEM.

FIG. 6 schematically illustrates a cross section of a transistor Tpx, a capacitor Cst, and a light-emitting element LE among the elements provided in each of the pixels PX. For example, to represent circuit elements provided in the pixel circuit PXC, FIG. 5 illustrates the transistor Tpx connected to the light-emitting element LE and the capacitor Cst connected to the gate electrode GE of the transistor Tpx. However, the cross section of the pixel PX may be changed in various ways depending on the type and/or structure or the like of each of the pixels PX. For example, the capacitor Cst may not be connected to the gate electrode of the transistor Tpx directly connected to the light-emitting element LE, and may be formed integrally with one electrode (e.g., the gate electrode) of another transistor provided to the pixel circuit PXC.

Referring to FIG. 6 in addition to FIGS. 1 to 5, the display device DD may include the first substrate SUB1, the second substrate SUB2, and the pixels PX and the sealing member SEM located and/or formed between the first substrate SUB1 and the second substrate SUB2. The pixels PX may be located and/or formed in the display area DA between the first substrate SUB1 and the second substrate SUB2, and the sealing member SEM may be located and/or formed in the non-display area NA between the first substrate SUB1 and the second substrate SUB2.

Each of the pixels PX may include a circuit unit (e.g., the pixel circuit PXC) including at least one transistor Tpx and the capacitor Cst, and a light-emitting unit including a pixel electrode PXE, the light-emitting element LE, and a common electrode CME. The light-emitting unit may be located on top of the circuit unit on the first substrate SUB1, but is not limited thereto. The display device DD may further include wires connected to the pixels PX. The wires may be formed concurrently or substantially simultaneously with the circuit unit of the pixel PX.

In addition, the display device DD may further include the circuit units and light-emitting units of the pixels PX, and active layers constituting and the wires, electrodes, conductive patterns, and/or insulating layers and/or insulating patterns located between and/or around the light-emitting elements LE. For example, the display device DD may include first, second, third, fourth, and fifth insulating layers INS1, INS2, INS3, INS4, and INS5 sequentially located on the first substrate SUB1. The first, second, third, fourth, and fifth insulating layers INS1, INS2, INS3, INS4, and INS5 may be located and/or formed in at least the display area DA. The first, second, third, fourth, and fifth insulating layers INS1, INS2, INS3, INS4, and INS5 may be located and/or formed in a portion of the non-display area NA (e.g., a portion of the non-display area NA adjacent to the display area DA), and may be removed from a sealing area (e.g., the edge area of the display device DD in which the first substrate SUB1 and the second substrate SUB2 are bonded by the sealing member SEM) provided with the sealing member SEM, but are not limited thereto. In addition, the display device DD may further include a bank BNK, an organic layer ORL, a capping layer CPL, or the like located around the light-emitting elements LE. In addition, the display device DD may further include an additional component (e.g., at least one conductive layer, a conductive pattern, a sensor layer, an insulating layer, and/or an insulating pattern, or the like).

The first substrate SUB1 may be a base member for forming a display panel of the display device DD including the pixels PX. The first substrate SUB1 may include the display area DA including the emission areas EA of the pixels PX and the non-emission area NEA around the emission areas EA (e.g., in plan view), and the non-display area NA around the display area DA (e.g., in plan view).

The first substrate SUB1 may be made of an insulating material, such as glass or polymer resin. As an example, the first substrate SUB1 may be a glass substrate made of glass or tempered glass. However, the material of the first substrate SUB1 is not limited thereto.

The first insulating layer INS1 may be located on the first substrate SUB1. The first insulating layer INS1 may be a buffer layer or a barrier layer. For example, the first insulating layer INS1 may protect the transistors Tpx, the light-emitting elements LE, and the like from moisture permeating through the first substrate SUB1.

The first insulating layer INS1 may include at least one inorganic layer containing an inorganic insulating material (e.g., silicon nitride, silicon oxide, silicon oxynitride, titanium oxide, aluminum oxide, or another inorganic insulating material). The first insulating layer INS1 may be a multilayer film composed of a plurality of inorganic layers. The material and/or structure of the first insulating layer INS1 may be changed.

At least one conductive pattern may be located between the first substrate SUB1 and the first insulating layer INS1. For example, a light-blocking layer (or back-gate electrode) overlapping the active layer ACT of at least one transistor Tpx and/or a conductive pattern including at least one wire (or a part of the at least one wire) may be located between the first substrate SUB1 and the buffer layer 121.

The circuit elements of the pixels PX including the transistors Tpx and the capacitors Cst, and wires (e.g., signal lines including the scan lines SL and the data lines DL, and power lines including the first power line VDL and the second power line VSL) connected to the pixels PX may be located on the first insulating layer INS1. Each transistor Tpx may include an active layer ACT, a gate electrode GE, a source electrode SE, and a drain electrode DE. Although FIG. 6 discloses implementations in which the transistor Tpx includes the source electrode SE and the drain electrode DE provided separately from the active layer ACT, the structure of the transistor Tpx may be changed. For example, at least one transistor Tpx provided in the pixel PX may not include the separate source electrode SE and/or drain electrode DE, and the source region and/or drain region of the active layer ACT may be formed integrally with the source electrode SE and/or the drain electrode DE of the corresponding transistor Tpx. Each capacitor Cst may include the first capacitor electrode CE1 and the second capacitor electrode CE2.

For example, a semiconductor layer including active layers ACT of the transistors Tpx may be located on the first insulating layer INS1. Each of the active layers ACT may be located in a pixel area (e.g., a pixel circuit area) of the pixel PX including the corresponding transistor Tpx. Each active layer ACT may include polycrystalline silicon, monocrystalline silicon, low-temperature polycrystalline silicon, amorphous silicon, or an oxide semiconductor material. Each of the active layers ACT may include a channel region that overlaps the gate electrode GE, and a source region and a drain region located on both sides of the channel region.

The second insulating layer INS2 may be located on the active layers ACT. The second insulating layer INS2 may be a gate-insulating layer covering the semiconductor layer including the active layers ACT. The second insulating layer INS2 may include at least one inorganic layer including an inorganic insulating material.

A first conductive layer (e.g., a first gate conductive layer) including the gate electrodes GE of the transistors Tpx may be located on the second insulating layer INS2. Each of the gate electrodes GE may overlap the active layer ACT of the corresponding transistor Tpx. Each gate electrode GE may include a conductive material (e.g., at least one of molybdenum (Mo), aluminum (Al), chromium (Cr), gold (Au), titanium (Ti), nickel (Ni), neodymium (Nd), copper (Cu), or other metals, an alloy thereof, or another conductive material), and may be a single-layer or multilayer electrode.

The first conductive layer may further include at least one wire (or a part of the at least one wire), a bridge pattern, and/or a capacitor electrode. As an example, the first conductive layer may further include first capacitor electrodes CE1 of the capacitors Cst. The first capacitor electrode CE1 of each of the capacitors Cst may be formed integrally with the gate electrode GE of the transistor Tpx connected thereto. Although FIG. 6 illustrates configurations in which the first capacitor electrode CE1 is formed integrally with the gate electrode GE of the transistor Tpx directly connected to the light-emitting element LE, the configurations are not limited thereto.

The third insulating layer INS3 may be located on the gate electrodes GE and the first capacitor electrodes CE1. The third insulating layer INS3 may be a second gate-insulating layer covering the first conductive layer including the gate electrodes GE and the first capacitor electrodes CE1. The third insulating layer INS3 may include at least one inorganic layer including an inorganic insulating material.

A second conductive layer (e.g., a second gate conductive layer) including the second capacitor electrodes CE2 of the capacitors Cst may be located on the third insulating layer INS3. Each of the second capacitor electrodes CE2 may overlap the first capacitor electrode CE1 of the corresponding capacitor Cst. Each of the second capacitor electrodes CE2 may be a single-layer or multilayer electrode containing a conductive material. The second conductive layer may further include at least one wire (or a part of the at least one wire) or the like.

The fourth insulating layer INS4 may be located on the second capacitor electrodes CE2. The fourth insulating layer INS4 may be an interlayer insulating layer that covers the second conductive layer including the second capacitor electrodes CE2. The fourth insulating layer INS4 may include at least one inorganic layer including an inorganic insulating material.

A third conductive layer (e.g., a source-drain conductive layer) including the source electrodes SE and drain electrodes DE of the transistors Tpx may be located on the fourth insulating layer INS4. Each of the source electrode SE and drain electrode DE may a single-layer or multilayer electrode including a conductive material. The source electrode SE and/or drain electrode DE of each of the transistors Tpx may be formed as the source region and/or drain region of the active layer ACT, and the third conductive layer may include at least one bridge electrode or the like connected to the source region and/or drain region of at least one transistor Tpx. The third conductive layer may further include at least one wire (or a part of the at least one wire), a bridge pattern, and/or a capacitor electrode. As an example, the third conductive layer may further include the first power line VDL (or a part of the first power line VDL) and/or the second power line VSL (or a part of the second power line VSL).

The fifth insulating layer INS5 may be located on the source electrodes SE and the drain electrodes DE. The fifth insulating layer INS5 may be a planarization layer (or via layer) covering the source electrodes SE and the drain electrodes DE. For example, the fifth insulating layer INS5 may include at least one organic layer containing an organic insulating material (e.g., acrylic resin, epoxy resin, phenolic resin, polyamide resin, polyimide resin, or another organic insulating material) to planarize the circuit unit where the transistors Tpx and the capacitors Cst are formed.

Although FIG. 6 illustrates a configuration in which one electrode of each of the transistors Tpx, for example, the drain electrode DE, is directly connected to the pixel electrode PXE provided in the light-emitting unit, the configuration is not limited thereto. For example, the display device DD may further include at least one conductive layer and/or insulating layer including a connection electrode and/or wire or the like located on the fifth insulating layer INS5. As an example, the display device DD may further include a fourth conductive layer including at least one wire and/or a connection electrode connecting the circuit unit to the light-emitting unit of each of the pixels PX, and a sixth insulating layer covering the fourth conductive layer.

The light-emitting unit including the pixel electrodes PXE, the light-emitting elements LE, and the common electrode CME of the pixels PX may be located on an insulating layer, for example, the fifth insulating layer INS5, covering the circuit unit including circuit elements and wires of the pixels PX including transistors Tpx and capacitors Cst. The light-emitting unit may further include the bank BNK defining and/or partitioning the emission areas EA of the pixels PX, the organic layer ORL surrounding at least a part of the light-emitting elements LE, and the capping layer CPL covering the common electrode CME.

For example, a pixel electrode layer including the pixel electrodes PXE of the pixels PX may be located on the fifth insulating layer INS5. Each of the pixel electrodes PXE may be connected to at least one transistor Tpx constituting the pixel circuit PXC of the corresponding pixel PX through at least one contact hole or via hole penetrating the fifth insulating layer INS5. Each pixel electrode PXE may include a conductive material (e.g., at least one of molybdenum (Mo), aluminum (Al), chromium (Cr), gold (Au), titanium (Ti), nickel (Ni), neodymium (Nd), copper (Cu), or other metals, an alloy thereof, or another conductive material) and may be a single-layer or multilayer electrode.

The pixel electrodes PXE are bonded to the light-emitting elements LE provided in each of the emission areas EA, and the sheet resistance of the pixel electrodes PXE may be lowered to reduce the contact resistance between the pixel electrodes PXE and the light-emitting elements LE. For example, the pixel electrodes PXE may be formed of a material with low sheet resistance, such as copper (Cu).

The bank BNK may be located on (e.g., above) the first substrate SUB1 on which the pixel electrodes PXE and the like are located. The bank BNK may be a pixel-defining layer that defines the emission areas EA in which each of the light-emitting elements LE is located, and may surround the emission areas EA. For example, the bank BNK may be a pattern located in the non-emission area NEA in the display area DA, and may have a mesh shape including openings corresponding to the emission areas EA when viewed in plan view. The bank BNK may cover the edges of each of the pixel electrodes PXE.

The bank BNK may be formed of an organic layer, such as acryl resin, epoxy resin, phenolic resin, polyamide resin, polyimide resin and the like. The bank BNK may include a light-blocking material to block or reduce light generated in the light-emitting element LE of each of the pixels PX from traveling to the adjacent pixel PX. For example, the bank BNK may contain an organic block pigment or an inorganic black pigment, such as carbon black or the like.

The light-emitting elements LE may be located on the first substrate SUB1 on which the pixel electrodes PXE, the bank BNK, and the like are located. The light-emitting elements LE may be located in each of the emission areas EA, and may be located on each of the exposed pixel electrodes PXE that is not covered by the bank BNK.

For example, at least one first light-emitting element LE1 located on the pixel electrode PXE of the first pixel PX1 may be located in the first emission area EA1 of the first pixel PX1. At least one second light-emitting element LE2 located on the pixel electrode PXE of the second pixel PX2 may be located in the second emission area EA2 of the second pixel PX2. At least one third light-emitting element LE3 located on the pixel electrode PXE of the third pixel PX3 may be located in the third emission area EA3 of the third pixel PX3.

The light-emitting elements LE may be formed by growing on a semiconductor substrate, such as a silicon wafer. Each of the light-emitting elements LE may be directly transferred from the semiconductor substrate onto the pixel electrode PXE of the first substrate SUB1. Alternatively, each of the light-emitting elements LE may be transferred onto the pixel electrodes PXE of the first substrate SUB1 through an electrostatic method using an electrostatic head or a stamping method using an elastic polymer material, such as PDMS or silicon as a transfer substrate.

The contact electrode CTE of each of the light-emitting elements LE (e.g., the contact electrode CTE of FIG. 4) may be located on each of the pixel electrodes PXE. Each of the contact electrode CTE and the pixel electrode PXE may be melt-bonded by heat and pressure. Alternatively, the contact electrode CTE and the pixel electrode PXE may be bonded to each other through a conductive adhesive member, such as an anisotropic conductive film (ACF) or an anisotropic conductive paste (ACP). Alternatively, the contact electrode CTE and the pixel electrode PXE may be bonded to each other through a soldering process. For example, the contact electrode CTE may include at least one of gold (Au), copper (Cu), aluminum (Al), or tin (Sn).

The organic layer ORL may be located on the portions of the pixel electrodes PXE that are not covered by the bank BNK and the light-emitting elements LE. The organic layer ORL may cover a part of the side surface and top surface of the bank BNK, and the height of the organic layer ORL may be greater than the height of the bank BNK. The organic layer ORL may be in contact with a part of the side surface of each of the light-emitting elements LE. The height of the organic layer ORL may be smaller than the height of each of the light-emitting elements LE. For example, the top surfaces of the light-emitting elements LE may not be covered by the organic layer ORL. The organic layer ORL may be a single-layer or multilayer organic layer containing acrylic resin, epoxy resin, phenolic resin, polyamide resin, and polyimide resin, or other organic materials.

The common electrode CME may be located on top of the light-emitting elements LE that are not covered by the organic layer ORL. The common electrode CME may be entirely located in the display area DA in which the bank BNK, the light-emitting elements LE, the organic layer ORL, and the like are located. For example, the common electrode CME may be located on the top surface of each of the light-emitting elements LE and the top surface of the organic layer ORL. The common electrode CME may also be located on a portion (e.g., an upper layer) of the side surface of each of the light-emitting elements LE. The common electrode CME may also be located on the exposed bank BNK that is covered by the organic layer ORL.

The common electrode CME may be a common layer commonly formed in the pixels PX of the display area DA including the first pixel PX1, the second pixel PX2, and the third pixel PX3. The common electrode CME may include a transparent conductive material capable of transmitting light. For example, the common electrode CME may be made of indium tin oxide (ITO), indium zinc oxide (IZO), or other transparent conductive materials. The pixel electrodes PXE may be an anode electrode of each of the pixels PX, and the common electrode CME may be a cathode electrode of the pixels PX.

The capping layer CPL may be located on the common electrode CME. The capping layer CPL may be entirely located in the display area DA (e.g., may entirely cover the display area DA) to cover the common electrode CME. The capping layer CPL may include at least one inorganic layer containing an inorganic insulating material (e.g., silicon nitride, silicon oxide, silicon oxynitride, titanium oxide, aluminum oxide, or another inorganic insulating material).

The second substrate SUB2 may be located on (e.g., above) the first substrate SUB1 on which the light-emitting unit including the light-emitting elements LE is located. The second substrate SUB2 may be an encapsulation substrate for encapsulating the display area DA including the pixels PX. The second substrate SUB2 may include the display area DA including the emission areas EA of the pixels PX and the non-emission area NEA around the emission areas EA, and the non-display area NA around the display area DA.

The second substrate SUB2 may be made of an insulating material, such as glass or polymer resin. As an example, the second substrate SUB2 may be a glass substrate made of glass or tempered glass. However, the material of the second substrate SUB2 is not limited thereto.

The second substrate SUB2 may include, or define, grooves GRV corresponding to the emission areas EA of the pixels PX. For example, the second substrate SUB2 may include the grooves GRV etched in a shape corresponding to each of the emission areas EA on one surface facing the first substrate SUB1. The grooves GRV may have a thickness or height of approximately 50% or less of the thickness of the second substrate SUB2 (e.g., a thickest portion of the second substrate SUB2), but are not limited thereto. For example, the thickness (or depth) at which the grooves GRV are formed may vary depending on the rigidity or thickness of the second substrate SUB2, the thickness of the light conversion layers LCVL and/or the color filters CF, or the like.

As an example, the second substrate SUB2 may include a first groove GRV1 corresponding to the first emission area EA1, a second groove GRV2 corresponding to the second emission area EA2, and a third groove GRV3 corresponding to the third emission area EA3. The first groove GRV1 may be located in the first emission area EA1, and may have a shape and/or area corresponding to the first emission area EA1. The second groove GRV2 may be located in the second emission area EA2, and may have a shape and/or area corresponding to the second emission area EA2. The third groove GRV3 may be located in the third emission area EA3, and may have a shape and/or area corresponding to the third emission area EA3.

The light conversion layers LCVL and the reflective layers RFL may be provided in the grooves GRV. The color filters CF may be further provided in the grooves GRV. For example, each of the color filters CF may be located between the bottom surface of each of the grooves GRV and the light conversion layer LCVL. The color filters CF may be provided on another surface, for example, the top surface, of the second substrate SUB2.

The light conversion layers LCVL may be located on the light-emitting elements LE located in each of the emission areas EA. For example, the light conversion layers LCVL may include the first light conversion layer LCVL1 provided in the first groove GRV1 and located on the first light-emitting element LE1 located in the first emission area EA1, the second light conversion layer LCVL2 provided in the second groove GRV2 and located on the second light-emitting element LE2 located in the second emission area EA2, and the third light conversion layer LCVL3 provided in the third groove GRV3 and located on the third light-emitting element LE3 located in the third emission area EA3.

The first pixel PX1, the second pixel PX2, and the third pixel PX3 may be pixels of different colors that emit light of different colors in the respective emission areas EA. For example, the first pixel PX1 may be a first color pixel that emits light of the first color in the first emission area EA1. The second pixel PX2 may be a second color pixel that emits light of the second color in the second emission area EA2. The third pixel PX3 may be a third color pixel that emits light of the third color in the third emission area EA3. As an example, the first pixel PX1, the second pixel PX2, and the third pixel PX3 may respectively be a blue pixel that emits blue light, a green pixel that emits green light, and a red pixel that emits red light.

The first pixel PX1, the second pixel PX2, and the third pixel PX3 may include the light-emitting elements LE that emit light of the same color. For example, the first light-emitting element LE1, the second light-emitting element LE2, and the third light-emitting element LE3 may be first color light-emitting elements (e.g., blue light-emitting elements that emit blue light) for emitting light of the first color.

A part of the light-emitting elements LE may be inserted into the grooves GRV located in each of the emission areas EA. For example, when a space is formed in the grooves GRV, the upper layer of the light-emitting elements LE, and a part of the common electrode CME and the capping layer CPL located on the light-emitting elements LE, may be inserted into the grooves GRV. Accordingly, the separation space between the first substrate SUB1 and the second substrate SUB2 may be reduced or minimized, and a light leakage path may be blocked, reduced, or minimized.

FIG. 6 discloses a configuration in which the capping layer CPL covering the common electrode CME is in contact with the light conversion layers LCVL (or a capping layer provided on the surface of the light conversion layers LCVL), but is not limited thereto. For example, the capping layer CPL and the light conversion layers LCVL (or the capping layer provided on the surface of the light conversion layers LCVL) may not be in contact with each other, and there may be a separation space therebetween.

The pixels PX may include the light conversion layers LCVL respectively including light conversion particles. Each of the light conversion layers LCVL may include light conversion particles of at least one type and/or material. Examples of the light conversion particles may include wavelength conversion particles (or color conversion particles), such as quantum dots and phosphors corresponding to the wavelength band of light of a corresponding color, and a light-scattering material SCT that scatters light.

At least some of the pixels PX may include wavelength conversion particles that convert light of the first color emitted from each of the light-emitting elements LE into light of a different color (e.g., light of a different wavelength band). For example, the second light conversion layer LCVL2 and the third light conversion layer LCVL3 may respectively be a color conversion layer (or wavelength conversion layer) including wavelength conversion particles corresponding to light of a corresponding color. The first light conversion layer LCVL1 may not include wavelength conversion particles.

The first light conversion layer LCVL1 may include a first base resin BRS1, and may selectively further include first light conversion particles. The first light conversion particles may include the light-scattering material SCT. For example, the first light conversion layer LCVL1 may be a light-scattering layer including the first base resin BRS1 and the light-scattering material SCT dispersed in the first base resin BRS1.

The first base resin BRS1 may include a light-transmissive organic material. For example, the first base resin BRS1 may contain epoxy resin, acrylic resin, cardo resin, or imide resin.

The light-scattering material SCT may have a refractive index different from that of the first base resin BRS1 and form an optical interface with the first base resin BRS1. For example, the light-scattering material SCT may be light scattering particles. The light-scattering material SCT is not particularly limited as long as it is a material capable of scattering at least a part of the transmitted light, and may be, for example, metal oxide particles or organic particles. Examples of the metal oxide may include titanium oxide (TiOz), silicon oxide (SiOz), zirconium oxide (ZrO₂), aluminum oxide (Al₂O₃), indium oxide (In₂O₃), zinc oxide (ZnO), tin oxide (SnOz), or the like. Examples of a material of the organic particles may include acrylic resin, urethane resin, or the like. The light-scattering material SCT may scatter light in a random direction irrespective of the incident direction of incident light, without substantially converting the wavelength of the light passing through the first light conversion layer LCVL1.

The second light conversion layer LCVL2 may include a second base resin BRS2 and second light conversion particles. The second light conversion particles may include first wavelength conversion particles WCP1 that convert light of the first color emitted from the second light-emitting element LE2 into light of the second color. For example, the second light conversion layer LCVL2 may include the second base resin BRS2, and the first wavelength conversion particles WCP1 dispersed in the second base resin BRS2. The second light conversion layer LCVL2 may further include a light-scattering material. The light-scattering material may be of the same type and/or material as the light-scattering material SCT provided in the first light conversion layer LCVL1, but is not limited thereto.

The second base resin BRS2 may contain a light-transmissive organic material. For example, the second base resin BRS2 may contain epoxy resin, acrylic resin, cardo resin, or imide resin.

The first wavelength conversion particles WCP1 may convert light of the first color emitted from the second light-emitting element LE2 into light of the second color. For example, the first wavelength conversion particles WCP1 may convert part of light of the first color emitted from the second light-emitting element LE2 into light of the second color. As an example, the first wavelength conversion particles WCP1 may convert part of the light in the blue wavelength band incident on the second light conversion layer LCVL2 into light in the green wavelength band. The first wavelength conversion particles WCP1 may be second color quantum dots (e.g., green quantum dots), quantum rods, fluorescent materials, or phosphorescent materials.

The third light conversion layer LCVL3 may include a third base resin BRS3 and third light conversion particles. The third light conversion particles may include second wavelength conversion particles WCP2 that convert light of the first color emitted from the third light-emitting element LE3 into light of the third color. For example, the third light conversion layer LCVL3 may include the third base resin BRS3, and the second wavelength conversion particles WCP2 dispersed in the third base resin BRS3. The third light conversion layer LCVL3 may further include a light-scattering material. The light-scattering material may be of the same type and/or material as the light-scattering material SCT provided in the first light conversion layer LCVL1, but is not limited thereto.

The third base resin BRS3 may contain a light-transmissive organic material. For example, the third base resin BRS3 may contain epoxy resin, acrylic resin, cardo resin, or imide resin.

The second wavelength conversion particles WCP2 may convert light of the first color emitted from the third light-emitting element LE3 into light of the third color. For example, the second wavelength conversion particles WCP2 may convert part of light of the first color emitted from the third light-emitting element LE3 into light of the third color. As an example, the second wavelength conversion particles WCP2 may convert part of the light in the blue wavelength band incident on the third light conversion layer LCVL3 into light in the red wavelength band. The second wavelength conversion particles WCP2 may be third color quantum dots (e.g., red quantum dots), quantum rods, fluorescent materials, or phosphorescent materials.

A capping layer may be provided on the surfaces of the light conversion layers LCVL. For example, a capping layer that is formed with at least one inorganic layer, and that encapsulates the light conversion layers LCVL, may be provided on the surfaces of the light conversion layers LCVL including the first light conversion layer LCVL1, the second light conversion layer LCVL2, and the third light conversion layer LCVL3.

The color filters CF may be located on the light conversion layers LCVL located in the respective grooves GRV to correspond to the emission areas EA, respectively. For example, the color filters CF may include the first color filter CF1 provided in the first groove GRV1 and located on the first light conversion layer LCVL1 provided in the first groove GRV1, the second color filter CF2 provided in the second groove GRV2 and located on the second light conversion layer LCVL2 provided in the second groove GRV2, and the third color filter CF3 provided in the third groove GRV3 and located on the third light conversion layer LCVL3 provided in the third groove GRV3.

The first color filter CF1 may be a color filter of the first color, which transmits light of the first color. For example, the first color filter CF1 may be a blue color filter that transmits light in the blue wavelength band. Accordingly, the first pixel PX1 may emit blue light.

The second color filter CF2 may be a color filter of the second color, which transmits light of the second color. For example, the second color filter CF2 may be a green color filter that transmits light in the green wavelength band, and that absorbs or blocks light in the blue wavelength band. As an example, the second color filter CF2 may transmit light in the green wavelength band converted by the second light conversion layer LCVL2 among light in the blue wavelength band emitted from the second light-emitting element LE2, and may absorb or block light in the blue wavelength band that has not been converted by the second light conversion layer LCVL2. Accordingly, the second pixel PX2 may emit green light.

The third color filter CF3 may be a color filter of the third color, which transmits light of the third color. For example, the third color filter CF3 may be a red color filter that transmits light in the red wavelength band, and that absorbs or blocks light in the blue wavelength band. As an example, the third color filter CF3 may transmit light in the red wavelength band converted by the third light conversion layer LCVL3 among light in the blue wavelength band emitted from the third light-emitting element LE3, and may absorb or block light in the blue wavelength band that has not been converted by the third light conversion layer LCVL3. Accordingly, the third pixel PX3 may emit red light.

The reflective layers RFL may be provided on the sidewalls of the grooves GRV, and may surround (e.g., partially surround) the light conversion layers LCVL. In the display device DD in which the color filters CF are provided in the grooves GRV, the reflective layers RFL may further surround the color filters CF. For example, each of the reflective layers RFL may be provided in the form of a reflective partition wall surrounding the side surfaces of the light conversion layer LCVL and the color filter CF provided in each of the grooves GRV, and may surround the light conversion layer LCVL and the color filter CF located in the corresponding emission area EA when viewed in plan view.

The reflective layers RFL may include the first reflective layer RFL1 provided in the first groove GRV1, the second reflective layer RFL2 provided in the second groove GRV2, and the third reflective layer RFL3 provided in the third groove GRV3. The first reflective layer RFL1 may be provided on a sidewall of the first groove GRV1, and may surround the first emission area EA1 when viewed in plan view. For example, the first reflective layer RFL1 may surround the first light conversion layer LCVL1 and the first color filter CF1 located in the first emission area EA1. The second reflective layer RFL2 may be provided in the second groove GRV2 and may surround the second emission area EA2 when viewed in plan view. For example, the second reflective layer RFL2 may surround the second light conversion layer LCVL2 and the second color filter CF2 located in the second emission area EA2. The third reflective layer RFL3 may be provided on a sidewall of the third groove GRV3 and may surround the third emission area EA3 when viewed in plan view. For example, the third reflective layer RFL3 may surround the third light conversion layer LCVL3 and the third color filter CF3 located in the third emission area EA3.

The reflective layers RFL may include at least one metal layer containing a metal material with a high reflectivity, such as aluminum (Al). The reflective layers RFL may function as a light-blocking member that blocks light from traveling in the lateral direction in the grooves GRV, and may increase the light emission efficiency of the pixels PX by reflecting light traveling in the lateral direction in each of the grooves GRV. Accordingly, the light efficiency of the pixels PX may be increased, and light interference between the pixels PX may be blocked, prevented, or reduced.

The first substrate SUB1 and the second substrate SUB2 may be bonded to each other by the sealing member SEM. The sealing member SEM may be provided between the first substrate SUB1 and the second substrate SUB2 in the non-display area NA to bond the first substrate SUB1 to the second substrate SUB2. For example, the sealing member SEM may be provided in the form of a closed loop surrounding the display area DA when viewed in plan view, and may seal at least the space between the first substrate SUB1 and the second substrate SUB2, on which the pixels PX are located.

The sealing member SEM may include a melted glass frit. For example, the sealing member SEM may be provided in a melted state of a frit containing glass powder.

As an example, the sealing member SEM may include crystallized base glass. Crystallized base glass may include fully crystallized (crystalline) glass as well as partially crystallized (semi-crystalline) glass. The base glass may be vanadium-based or palladium-based. The base glass may further include tellurium oxide, zinc oxide, barium oxide, or the like. The sealing member SEM may further include a filler. The filler may include a ceramic material. The filler may be dispersed in the base glass, and may serve to maintain the shape of the crystallized base glass.

After the sealing member SEM made of glass frit or the like is located between the first substrate SUB1 and the second substrate SUB2, when a laser is irradiated, a part of the sealing member SEM is melted by the energy of the laser, so that the sealing member SEM may be bonded to the first substrate SUB1 and the second substrate SUB2.

The sealing member SEM may reduce or prevent oxygen and/or moisture from permeating into the cell gap from the outside of the display device DD (e.g., a display panel including the first substrate SUB1 and the second substrate SUB2). The sealing member SEM including a glass frit may improve the bonding strength between the first substrate SUB1 and the second substrate SUB2.

The second substrate SUB2, which includes/defines the grooves GRV corresponding to the emission areas EA, and which has the light conversion layers LCVL or the like provided in the grooves GRV, may be located on the first substrate SUB1 in close contact therewith, and the first substrate SUB1 and the second substrate SUB2 may be bonded to each other by using the sealing member SEM. As a result, the first substrate SUB1 and the second substrate SUB2 may be stably bonded without separately arranging an optically clear adhesive (OCA), an optically clear resin (OCR), or the like between the first substrate SUB1 and the second substrate SUB2. Accordingly, light generated from each of the pixels PX may be reduced or prevented from leaking to adjacent pixels through a transparent layer, such as OCA or OCR provided between the first substrate SUB1 and the second substrate SUB2. As a result, image quality degradation of the display device DD due to light interference between the pixels PX may be reduced, prevented, or minimized.

However, the examples are not limited to the display device DD that does not include OCA or OCR. For example, the display device DD may include a transparent layer, such as OCA or OCR provided with a limited thickness between the first substrate SUB1 and the second substrate SUB2. In this case, by reducing or minimizing the thickness of the transparent layer to, for example, about 5 µm or less, light leakage between the pixels PX may be reduced, prevented, or minimized.

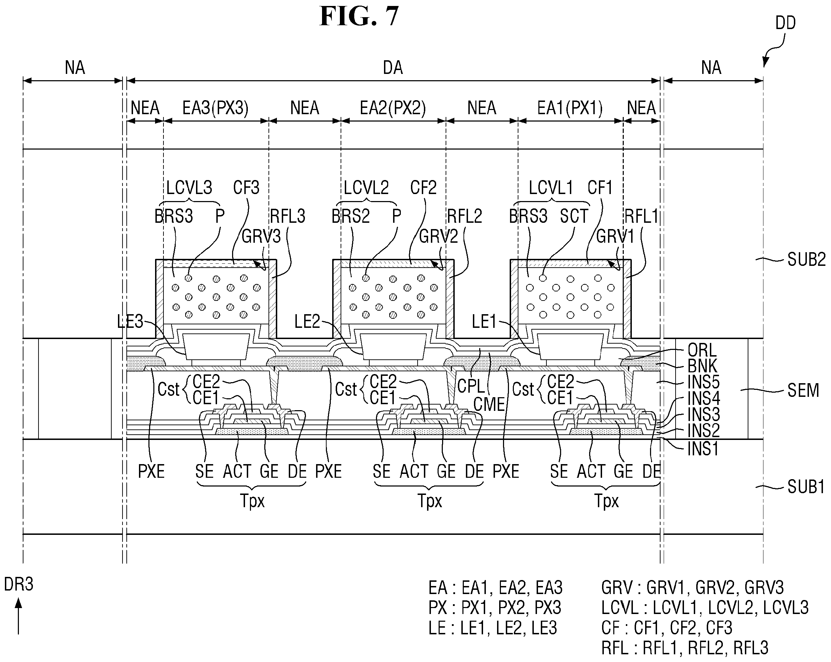

FIG. 7 is a cross-sectional view illustrating the display device DD. For example, FIG. 7 illustrates the display device DD that is different from the one or more examples corresponding to FIG. 6 with respect to the second light conversion layer LCVL2 and the third light conversion layer LCVL3. In describing the following, including the configurations corresponding to FIG. 7, detailed descriptions of configurations similar or identical to those of the previously described examples will be omitted.

Referring to FIG. 7 in addition to FIGS. 1 to 6, the second light conversion layer LCVL2 and the third light conversion layer LCVL3 may contain phosphors P that convert light of the first color into light of the fourth color (e.g., yellow light). For example, the second light conversion layer LCVL2 may include the second base resin BRS2 and the phosphors P dispersed in the second base resin BRS2, and the third light conversion layer LCVL3 may include the third base resin BRS3 and the phosphors P dispersed in the third base resin BRS3.

The phosphors P may convert part of light of the first color emitted from the second light-emitting element LE2 and the third light-emitting element LE3 into light of the fourth color. As an example, the phosphors P may convert part of the light in the blue wavelength band incident on the second light conversion layer LCVL2 and the third light conversion layer LCVL3 into light in the yellow wavelength band. Accordingly, white light may be emitted from the second light conversion layer LCVL2 and the third light conversion layer LCVL3. The light emitted from the second light conversion layer LCVL2 may be incident on the second color filter CF2, and light of the second color (e.g., green light) may be emitted from the second emission area EA2 by the second color filter CF2. The light emitted from the third light conversion layer LCVL3 may be incident on the third color filter CF3, and light of the third color (e.g., red light) may be emitted from the third emission area EA3 by the third color filter CF3.

The phosphors P may be organic phosphors or another different fluorescent material that absorbs light in the blue wavelength band incident on the second light conversion layer LCVL2 and the third light conversion layer LCVL3, and that emits yellow light. The second light conversion layer LCVL2 and the third light conversion layer LCVL3 may include phosphors P of the same type and/or material, and may be formed concurrently or substantially simultaneously on the second substrate SUB2. The second light conversion layer LCVL2 and the third light conversion layer LCVL3 may further include a light-scattering material.

The first light conversion layer LCVL1 may include the light-scattering material SCT. For example, the first light conversion layer LCVL1 may include the first base resin BRS1 and the light-scattering material SCT.

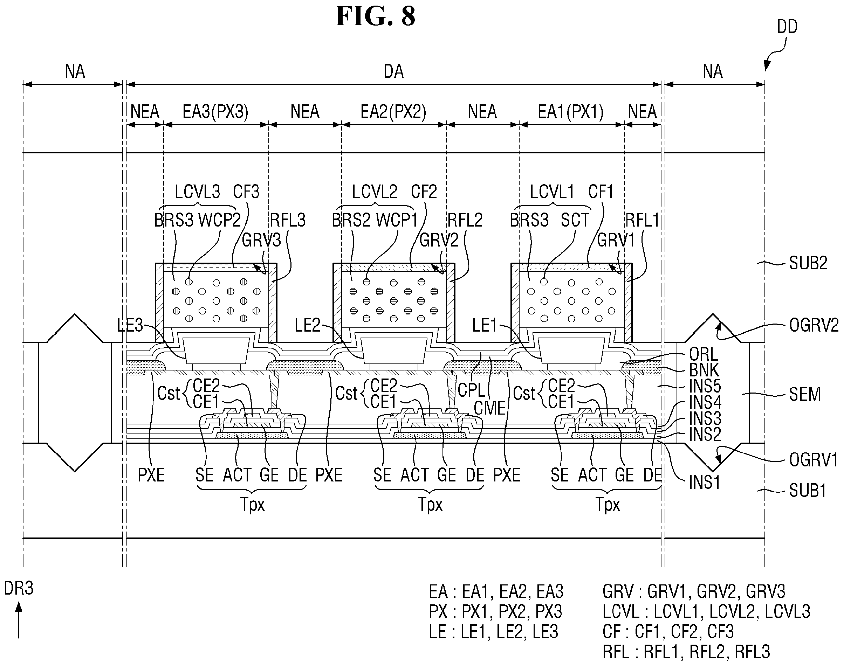

FIG. 8 is a cross-sectional view illustrating the display device DD. For example, FIG. 8 illustrates the display device DD that is different from the one or more examples corresponding to FIG. 6 with respect to the first substrate SUB1 and the second substrate SUB2. The first substrate SUB1 and the second substrate SUB2 according to the one or more examples corresponding to FIG. 8 may also be applied to the display device DD according to the one or more examples corresponding to FIG. 7.

Referring to FIG. 8 in addition to FIGS. 1 to 7, the first substrate SUB1 and the second substrate SUB2 may further include outer grooves located in the non-display area NA in which the sealing member SEM is provided. The outer grooves may overlap the sealing member SEM.

For example, the first substrate SUB1 may include/define a first outer groove OGRV1 that overlaps the sealing member SEM on one surface facing the second substrate SUB2. The first outer groove OGRV1 may be formed in the first substrate SUB1 in a closed loop shape surrounding the display area DA when viewed in plan view. A portion of the sealing member SEM may be located in the first outer groove OGRV1.

The second substrate SUB2 may include a second outer groove OGRV2 that overlaps the sealing member SEM on one surface facing the first substrate SUB1. The second outer groove OGRV2 may be formed in the second substrate SUB2 in a closed loop shape surrounding the display area DA when viewed in plan view. Another portion of the sealing member SEM may be located in the second outer groove OGRV2.

According to the above, an increase in the separation distance between the first substrate SUB1 and the second substrate SUB2 due to the sealing member SEM may be reduced, prevented, or minimized. For example, when the separation distance between the first substrate SUB1 and the second substrate SUB2 increases due to the thickness of the sealing member SEM for the stable bonding of the first substrate SUB1 and the second substrate SUB2, the first outer groove OGRV1 and/or the second outer groove OGRV2 may be formed at a position corresponding to the sealing member SEM in at least one of the first substrate SUB1 or the second substrate SUB2. As a result, the first substrate SUB1 and the second substrate SUB2 may be stably bonded using the sealing member SEM, and the first substrate SUB1 and the second substrate SUB2 may be located in close contact.

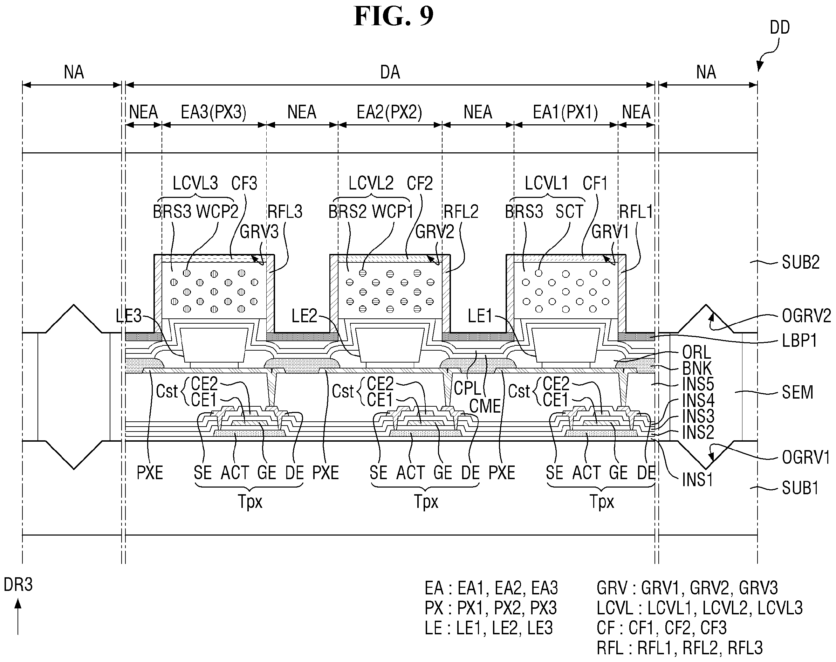

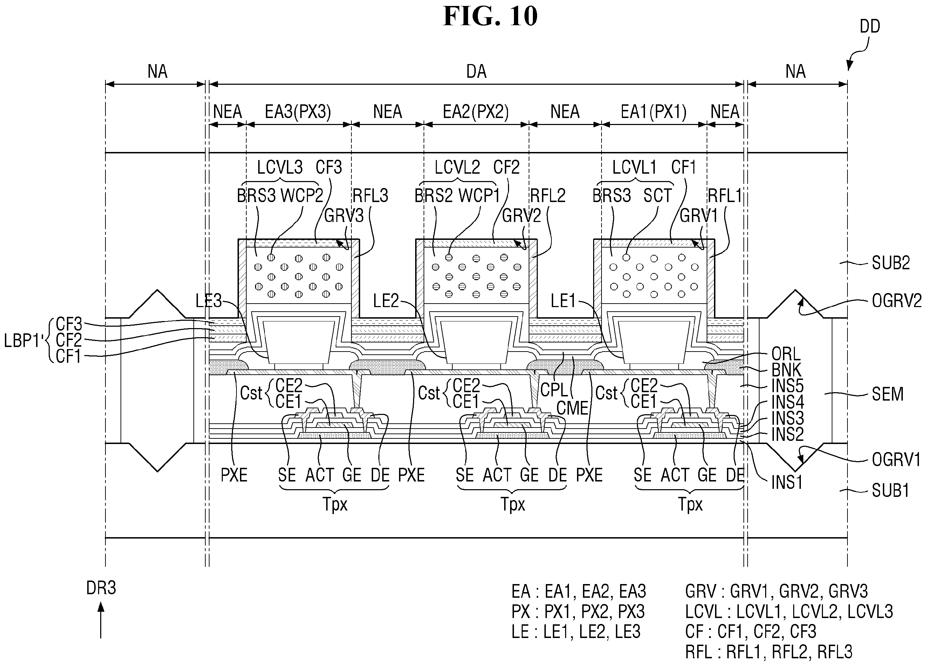

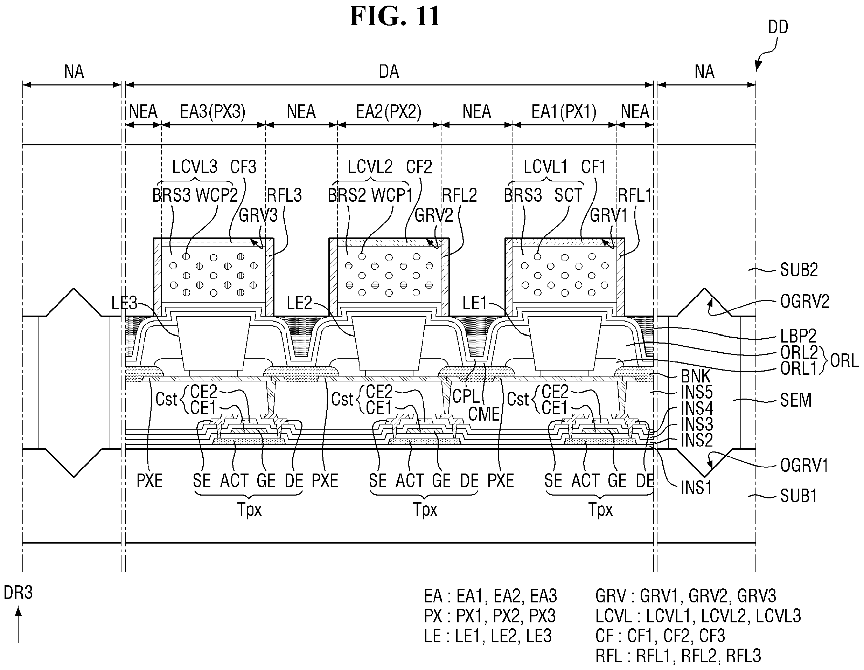

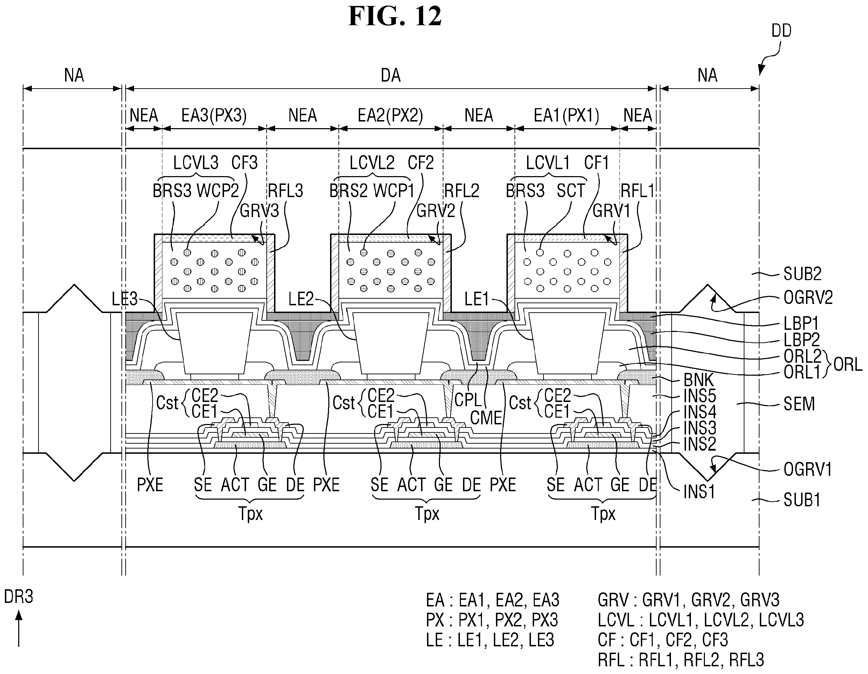

FIG. 9 is a cross-sectional view illustrating the display device DD. FIG. 10 is a cross-sectional view illustrating the display device DD. FIG. 11 is a cross-sectional view illustrating the display device DD. FIG. 12 is a cross-sectional view illustrating the display device DD.

For example, FIGS. 9 to 12 illustrate the display devices DD according to different examples with respect to light-blocking patterns that may be additionally applied to the display device DD according to the one or more examples corresponding to FIG. 6. The light-blocking patterns (e.g., a first light-blocking pattern LBP1 or LBP1') and/or a second light-blocking pattern LBP2) according to the examples of FIGS. 9 to 12 may also be applied to the display device DD according to the one or more examples corresponding to FIGS. 7 and/or 8.

First, referring to FIG. 9 in addition to FIGS. 1 to 8, the display device DD may further include the first light-blocking pattern LBP1 located in the non-emission area NEA of the display area DA. The first light-blocking pattern LBP1 may be located between the emission areas EA, and may surround the emission areas EA. For example, the first light-blocking pattern LBP1 may be a mesh-shaped pattern including openings corresponding to the emission areas EA when viewed in plan view.

The first light-blocking pattern LBP1 may be located and/or formed on one surface of the second substrate SUB2 facing the first substrate SUB1. As the first substrate SUB1 and the second substrate SUB2 are bonded, the first light-blocking pattern LBP1 may be located on the bank BNK.

The first light-blocking pattern LBP1 may include a light-blocking material to block, reduce, or prevent light emitted from the one pixel PX from traveling to the adjacent pixel PX. For example, the first light-blocking pattern LBP1 may block light emitted from the emission area EA of each of the pixels PX from traveling in the lateral direction of the display device DD, rather than the upward direction.

The first light-blocking pattern LBP1 may include a black matrix material including an inorganic black pigment, such as carbon black or an organic black pigment. However, the material of the first light-blocking pattern LBP1 is not limited thereto. For example, the first light-blocking pattern LBP1 may be formed of a single-layer or multilayer metal layer including at least one metal.

Referring to FIG. 10 in addition to FIGS. 1 to 9, the display device DD may include the first light-blocking pattern LBP1' of at least a double layer including color filter materials of at least two colors. For example, the first light-blocking pattern LBP1' may have a structure in which the first color filter CF1, the second color filter CF2, and the third color filter CF3 are stacked. If the target light-blocking effect may be obtained with only the two color filters CF among the first color filter CF1, the second color filter CF2, and the third color filter CF3, the first light-blocking pattern LBP1' may include only the two color filters CF among the first color filter CF1, the second color filter CF2, and the third color filter CF3. As an example, the first light-blocking pattern LBP1' may have a double-layer structure in which the first color filter CF1 and the third color filter CF3 are stacked.

The first light-blocking pattern LBP1' may be located and/or formed on one surface of the second substrate SUB2 facing the first substrate SUB1. When the first light-blocking pattern LBP1' includes the same material as the color filters CF provided in the emission areas EA, in the step of forming the color filters CF in the emission areas EA, the first light-blocking pattern LBP1' may be formed in the non-emission area NEA.

The light conversion layers LCVL (or the capping layer covering the light conversion layers LCVL) may contact, or might not contact, the capping layer CPL covering the common electrode CME. For example, according to the height, thickness, or the like of each element provided on the first substrate SUB1 and the second substrate SUB2 or the corresponding structure, the element provided and/or formed on the first substrate SUB1 and the element provided and/or formed on the second substrate SUB2 in each of the grooves GRV may be in close contact, or there may be a gap between the two elements.

Referring to FIG. 11 in addition to FIGS. 1 to 10, the organic layer ORL provided on the side surface of the light-emitting elements LE may be provided in a structure of at least a double layer including a first organic layer ORL1 and a second organic layer ORL2. For example, when the light-emitting elements LE protrude upward by a greater height and/or thickness than the bank BNK or the like, the organic layer ORL of at least a double layer may be formed to flatten the stepped portion due to the light-emitting elements LE.

The height of the organic layer ORL (e.g., the sum of the heights of the first organic layer ORL1 and the second organic layer ORL2) may be less than or equal to the heights of the light-emitting elements LE. For example, the height of the organic layer ORL (e.g., the sum of the heights of the first organic layer ORL1 and the second organic layer ORL2) may be lower than the heights of the light-emitting elements LE. Accordingly, the common electrode CME may be stably in contact with and/or connected to the top surface of each of the light-emitting elements LE.

The first organic layer ORL1 and the second organic layer ORL2 may include acryl resin, epoxy resin, phenolic resin, polyamide resin, polyimide resin, or another organic material. The first organic layer ORL1 and the second organic layer ORL2 may include the same organic material or different organic materials.

The display device DD may further include the second light-blocking pattern LBP2 located in the non-emission area NEA of the display area DA. The second light-blocking pattern LBP2 may be located between the emission areas EA, and may surround the emission areas EA. For example, the second light-blocking pattern LBP2 may be a mesh-shaped pattern including openings corresponding to the emission areas EA when viewed in plan view.

The second light-blocking pattern LBP2 may be located and/or formed on one surface of the first substrate SUB1 facing the second substrate SUB2. As an example, the second light-blocking pattern LBP2 may be located on the capping layer CPL to overlap the bank BNK.

The second light-blocking pattern LBP2 may include a light-blocking material to block, reduce, or prevent light emitted from the one pixel PX from traveling to the adjacent pixel PX. For example, the second light-blocking pattern LBP2 may block light emitted from the emission area EA of each of the pixels PX from traveling in the lateral direction of the display device DD rather than the upward direction.

The second light-blocking pattern LBP2 may be formed as a single-layer or multilayer organic layer including acryl resin, epoxy resin, phenolic resin, polyamide resin, polyimide resin, or the like. The second light-blocking pattern LBP2 may include a light-blocking material to block, reduce, or prevent light emitted from the one pixel PX from traveling to the adjacent pixel PX. For example, the second light-blocking pattern LBP2 may include an inorganic black pigment, such as carbon black or an organic black pigment. However, the material of the second light-blocking pattern LBP2 is not limited thereto. For example, the second light-blocking pattern LBP2 may be formed as a single-layer or multilayer light-blocking layer including at least one metal or the color filter materials of at least two colors.

Referring to FIG. 12 in addition to FIGS. 1 to 11, the display device DD may include the first blocking pattern LBP1 (or the first blocking pattern LBP1' of FIG. 10) and the second light-blocking pattern LBP2 overlapping each other in the non-emission area NEA. For example, the display device DD may include the first light-blocking pattern LBP1 located and/or formed on one surface of (e.g., below) the second substrate SUB2, and the second light-blocking pattern LBP2 located and/or formed on one surface of (e.g., above) the first substrate SUB1. Accordingly, the likelihood of light generated in the emission area EA of each of the pixels PX traveling to the adjacent pixel PX may be effectively reduced or prevented.

As described above, the display device DD may include the first substrate SUB1, the light-emitting elements LE located in the emission areas EA on the first substrate SUB1, the second substrate SUB2 including the grooves GRV corresponding to the emission areas EA on one surface facing the first substrate SUB1, the light conversion layers LCVL provided in the grooves GRV, and the reflective layers RFL. The display device DD may further include the color filters CF provided in the grooves GRV to be located on top of the light conversion layers LCVL. Crosstalk due to light interference between the pixels PX may be reduced or prevented, and image quality of the display device DD may be improved.

The display device DD may further include at least one of a first outer groove GRV1 provided in the non-display area NA of the first substrate SUB1 while overlapping the sealing member SEM, or a second outer groove GRV2 provided in the non-display area NA of the second substrate SUB2 while overlapping the sealing member SEM. An increase in the separation distance between the first substrate SUB1 and the second substrate SUB2 due to the sealing member SEM may be reduced, prevented, or minimized. Accordingly, the light leakage path between the pixels PX may be blocked or minimized, and the thickness of the display device DD may be reduced.

The display device DD may further include at least one of the first light-blocking pattern LBP1 or LBP1' or the second light-blocking pattern LBP2 provided in the non-emission area NEA. Accordingly, the likelihood of light generated in the emission area EA of each of the pixels PX traveling to the adjacent pixels PX may be reduced or prevented.

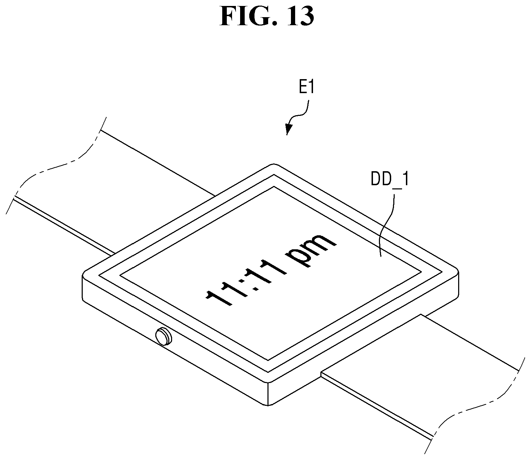

FIG. 13 is a diagram illustrating a smart device including a display device DD_1.

Referring to FIG. 13, the display device DD_1 may be applied to a smart watch E1 that is one of the smart devices. The planar shape of the clock display unit of the smart watch E1 may follow the planar shape of the display device DD_1. For example, when the display device DD_1 has a quadrilateral planar shape, the clock display unit of the smart watch E1 may have a quadrilateral planar shape. Alternatively, when the display device DD_1 has a circular or elliptical planar shape, the watch display unit of the smart watch E1 may have a circular or elliptical planar shape. However, it is not limited thereto, and the clock display unit of the smart watch E1 may not follow the planar shape of the display device DD_1.

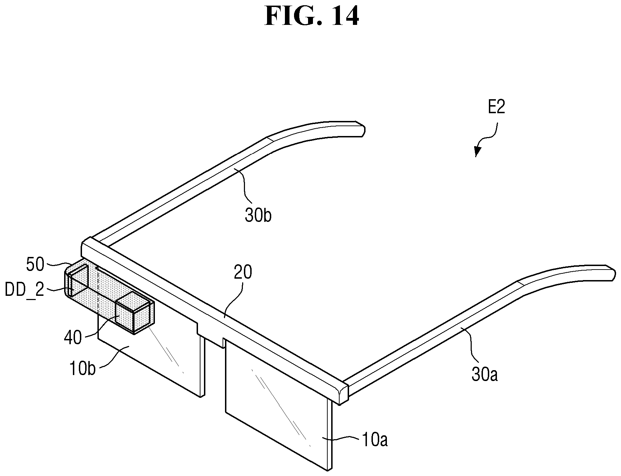

FIG. 14 is a diagram illustrating a virtual reality device E2 including a display device DD_2. FIG. 14 illustrates a virtual reality device E2 to which the display device DD_2 is applied.

Referring to FIG. 14, the virtual reality device E2 may be a glass-type device. The virtual reality device E2 may include the display device DD_2, a left lens 10a, a right lens 10b, a support frame 20, temples 30a and 30b, a reflective member 40, and a display device housing 50.

Although FIG. 14 illustrates the virtual reality device E2 including the temples 30a and 30b, the virtual reality device E2 may be applied to a head mounted display including a head mounted band that may be worn on a head, instead of the temples 30a and 30b. That is, the virtual reality device E2 is not limited to the form shown in FIG. 14, and may be applied in various forms to various electronic devices.

The display device housing 50 may include the display device DD_2 and the reflective member 40. An image displayed on the display device DD_2 may be reflected by the reflective member 40 and provided to the user's right eye through the right lens 10b. As a result, the user may view a virtual reality image displayed on the display device DD_2 with the right eye.

Although FIG. 14 illustrates that the display device housing 50 is located at the right end of the support frame 20, it is not limited thereto. For example, the display device housing 50 may be located at the left end of the support frame 20. In this case, an image displayed on the display device DD_2 may be reflected by the reflective member 40, and provided to the user's left eye through the left lens 10a. As a result, the user may view a virtual reality image displayed on the display device DD_2 with the left eye. Alternatively, the display device housings 50 may be located at both the left and right ends of the support frame 20. In this case, the user views a virtual reality image displayed on the display device DD_2 with both the left and right eyes.

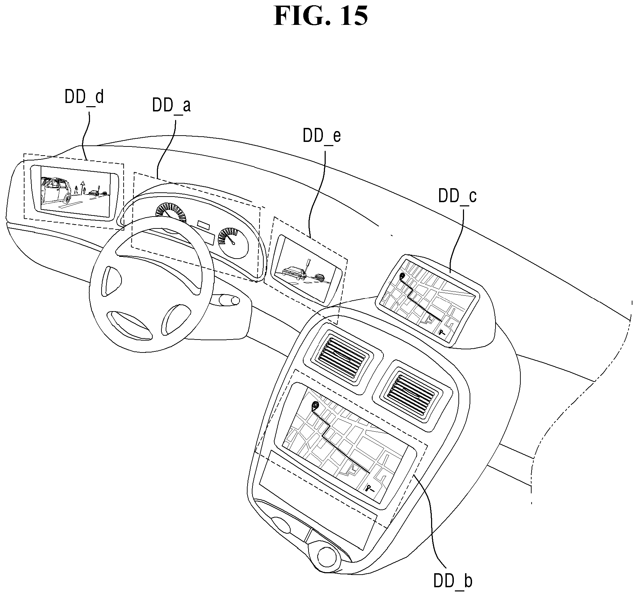

FIG. 15 is a diagram illustrating an automobile dashboard and center fascia including display devices DD_a, DD_b, DD_c, DD_d, and DD_e. FIG. 15 illustrates a vehicle to which display devices DD_a, DD_b, DD_c, DD_d, and DD_e are applied.

Referring to FIG. 15, the display devices DD_a, DD_b, and DD_c may be applied to the dashboard of the automobile, the center fascia of the automobile, or the center information display (CID) of the dashboard of the automobile. Further, the display devices DD_d, and DD_e may be applied to a room mirror display instead of side mirrors of the automobile.

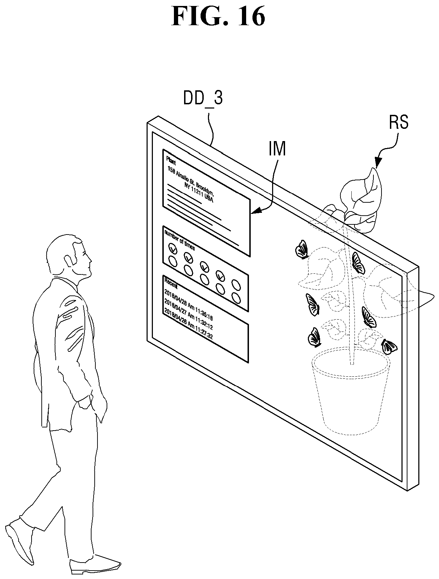

FIG. 16 is a diagram illustrating a transparent display device including a display device DD_3.

Referring to FIG. 16, the display device DD_3 may be applied to the transparent display device. The transparent display device may display an image IM, and also may transmit light. Accordingly, a user located on the front side of the transparent display device can view an object RS or a background on the rear side of the transparent display device as well as the image IM displayed on the display device DD_3. When the display device DD_3 is applied to the transparent display device, the first substrate SUB1 and the second substrate SUB2 of the display device DD_3 may include a light-transmitting portion capable of transmitting light or may be made of a material capable of transmitting light.

In concluding the detailed description, those skilled in the art will appreciate that many variations and modifications can be made to the embodiments without substantially departing from the scope of the invention as defined by the claims.

## Claims

1. A display device comprising:
a first substrate comprising emission areas, and a non-emission area between the emission areas;
light-emitting elements above the first substrate and respectively in the emission areas;
a second substrate above the first substrate, and defining grooves corresponding to the emission areas on a surface facing the first substrate;
light conversion layers in the grooves above the light-emitting elements; and
reflective layers on sidewalls of the grooves, and surrounding the light conversion layers in plan view.

2. The display device of claim 1, wherein the emission areas comprise a first emission area for emitting light of a first color, a second emission area for emitting light of a second color, and a third emission area for emitting light of a third color, and
wherein the grooves comprise a first groove corresponding to the first emission area, a second groove corresponding to the second emission area, and a third groove corresponding to the third emission area.

3. The display device of claim 2, further comprising:
a first color filter in the first groove, above a first light conversion layer in the first groove, and for transmitting light of the first color;
a second color filter in the second groove, above a second light conversion layer in the second groove, and for transmitting light of the second color; and
a third color filter in the third groove, above a third light conversion layer in the third groove, and for transmitting light of the third color.

4. The display device of claim 2 or 3, wherein the light-emitting elements comprise a first light-emitting element in the first emission area, a second light-emitting element in the second emission area, and a third light-emitting element in the third emission area, the first light-emitting element, the second light-emitting element, and the third light-emitting element comprising first color light-emitting elements for emitting light of the first color.

5. The display device of claim 4, wherein the light conversion layers comprise:
a first light conversion layer in the first groove, and containing a light-scattering material;
a second light conversion layer in the second groove, and comprising first wavelength conversion particles for converting the light of the first color into the light of the second color; and
a third light conversion layer in the third groove, and comprising second wavelength conversion particles for converting the light of the first color into the light of the third color.

6. The display device of claim 4, wherein the light conversion layers comprise:
a first light conversion layer in the first groove, and containing a light-scattering material;
a second light conversion layer in the second groove, and comprising phosphors for converting the light of the first color into light of a fourth color; and
a third light conversion layer in the third groove, and comprising phosphors for converting the light of the first color into the light of the fourth color.

7. The display device of claim 4, 5 or 6, wherein the first light-emitting element, the second light-emitting element, and the third light-emitting element comprise blue light-emitting elements for emitting blue light.

8. The display device of any one of the preceding claims, wherein the light-emitting elements are partially inserted into the grooves.

9. The display device of any one of the preceding claims, wherein the first substrate and the second substrate comprise a display area comprising the emission areas and the non-emission area, and a non-display area surrounding the display area in plan view,
wherein the display device further comprises a sealing member between the first substrate and the second substrate in the non-display area.

10. The display device of claim 9, wherein the sealing member comprises a melted glass frit, and/or wherein the first substrate and the second substrate comprise glass.

11. The display device of claim 9 or 10, wherein the first substrate defines a first outer groove in the non-display area on a surface facing the second substrate, and
wherein the second substrate further defines a second outer groove in the non-display area on the surface facing the first substrate.

12. The display device of claim 11, wherein a portion of the sealing member is in the first outer groove, and
wherein another portion of the sealing member is in the second outer groove.

13. The display device of any one of the preceding claims, further comprising at least one of:
a first light-blocking pattern on the surface of the second substrate, and in the non-emission area; or
a second light-blocking pattern on a surface of the first substrate, and in the non-emission area, optionally wherein the first light-blocking pattern and the second light-blocking pattern comprise a black matrix material, a metal, or color filter materials of at least two colors.

14. The display device of any one of the preceding claims, wherein the reflective layers comprise at least one metal layer.

15. The display device of any one of the preceding claims, further comprising pixels in a display area comprising the emission areas and the non-emission area, and comprising respective light-emitting elements, respective light conversion layers, and respective reflective layers in the emission areas.
